(19) Europäisches Patentamt
European Patent Office
Office européen des brevets

(11) **EP 3 493 404 A2**

(12) **EUROPÄISCHE PATENTANMELDUNG**

(43) Veröffentlichungstag:
**05.06.2019 Patentblatt 2019/23**

(51) Int Cl.:
***H03L 7/06*** *(2006.01)*

(21) Anmeldenummer: **18205905.5**

(22) Anmeldetag: **13.11.2018**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **13.11.2017 DE 102017220173**

(71) Anmelder: **Helmut-Schmidt-Universität 22043 Hamburg (DE)**

(72) Erfinder:
• **Terörde, Michael**
 **12203 Berlin (DE)**
• **Grumm, Florian**
 **12587 Berlin (DE)**
• **Schulz, Detlev**
 **22043 Hamburg (DE)**
• **Brombach, Johannes**
 **13437 Berlin (DE)**

(74) Vertreter: **Maiwald Patent- und Rechtsanwaltsgesellschaft mbH Elisenhof Elisenstraße 3 80335 München (DE)**

(54) **REGELKREIS FÜR EIN VERSORGUNGSNETZ UND PHASENSCHIEBER**

(57) Regelkreis (3) für ein Versorgungsnetz (31) mit drei Außenleitern ($L_1$, $L_2$, $L_3$), umfassend einen Phasenschieber (1, la-lc) für jeden Außenleiter ($L_1$, $L_2$, $L_3$) des Versorgungsnetzes (31), mindestens einen Sensor (32a-32c) zur Messung der Spannung ($U_i$, $U_2$, $U_3$), des Stroms ($I_1$, $I_2$, $I_3$) und/oder des Phasenwinkels ($\phi_1$, $\phi_2$, $\phi_3$) in jedem Außenleiter ($L_1$, $L_2$, $L_3$) des Versorgungsnetzes (31) sowie mindestens eine Regeleinheit (33, 33a-33c), wobei die Regeleinheit (33, 33a-33c) dazu ausgebildet ist, die Spannung ($U_i$, $U_2$, $U_3$), den Strom ($I_1$, $I_2$, $I_3$) und/oder den Phasenwinkel ($\phi_1$, $\phi_2$, $\phi_3$) in einem oder mehreren Außenleitern ($L_1$, $L_2$, $L_3$) auf einen Sollwert zu regeln, indem sie aus der jeweiligen Abweichung vom Sollwert eine Phasenverschiebung ($\varphi_1$-$\varphi_3$) als Stellgröße (21) ermittelt und dem Phasenschieber (1, la-lc) zuführt, wobei der Phasenschieber (1, la-lc) einen vollanalogen Signalpfad (26) aufweist, den das Signal mindestens eines Außenleiters ($L_1$, $L_2$, $L_3$) zur Aufprägung der Phasenverschiebung ($\varphi_1$-$\varphi_3$) durchläuft.

Zugehöriger Phasenschieber (1, 1a-1c), umfassend:
• einen ersten analogen Multiplizierer (13a) zur Multiplikation des Kosinussignals (11b) mit einem Sinus (14a) des Winkels $\varphi$,
• einen zweiten analogen Multiplizierer (13b) zur Multiplikation des Sinussignals (11a) mit einem Kosinus (14b) des Winkels $\varphi$ und
• einen analogen Addierer oder analogen Subtrahierer (15) zur Addition der von beiden analogen Multiplizierern ausgegebenen Produkte.

Fig. 1

EP 3 493 404 A2

**Beschreibung**

Die Erfindung betrifft einen Regelkreis für ein Versorgungsnetz, der insbesondere als Netznachbildung verwendbar ist, sowie einen Phasenschieber, der als Stellglied in diesem Regelkreis verwendbar ist.

Stand der Technik

Eine Netznachbildung ist ein elektrotechnisches Prüfgerät, mit dem die Reaktion eines Prüflings auf einen vorgegebenen Zustand des Versorgungsnetzes erfasst werden kann. Beispielsweise kann dem Prüfling ein Netzzustand mit gegenüber dem Nominalzustand veränderter Spannung, Frequenz und/oder Phasenlage präsentiert werden. Auf diese Weise kann beispielsweise geprüft werden, inwieweit ein Windkraftgenerator, ein Motor oder ein Umrichter in der Lage ist, eine unsymmetrische Einspeisung aus dem Versorgungsnetz zu tolerieren. Dabei können die Spannung, die Frequenz, und/oder die Phasenlage, auch nach einem Zeitprogramm gefahren werden. Das Grundprinzip einer Netznachbildung ist beispielsweise der GB 1 312 618 A zu entnehmen. Eine Netznachbildung kann optional auch Messmittel zur Erfassung der von dem Prüfling emittierten leitungsgebundenen Störsignale aufweisen und somit als Werkzeug für die Verbesserung der elektromagnetischen Verträglichkeit dienen.

Bei herkömmlichen Netznachbildungen ist die Vorgabe der Spannung, der Frequenz und/oder der Phasenlage starr, d.h., dem Prüfling wird unabhängig von der Leistung, die er aus der Netznachbildung bezieht, immer der gleiche Netzzustand präsentiert. Dieses Verhalten entspricht nicht dem Verhalten realer Spannungsquellen oder Erzeugungseinheiten, die auf eine Lastanforderung grundsätzlich dynamisch reagieren.

Aufgabe und Lösung

Es ist daher die Aufgabe der Erfindung, einen Regelkreis für ein Versorgungsnetz zur Verfügung zu stellen, mit dem das lastabhängige dynamische Verhalten realer Spannungsquellen und Erzeugungseinheiten abgebildet werden kann.

Diese Aufgabe wird erfindungsgemäß gelöst durch einen Regelkreis gemäß Hauptanspruch und durch einen Phasenschieber gemäß Nebenanspruch, der als zentrales Element in dem Regelkreis verwendbar ist. Weitere vorteilhafte Ausgestaltungen ergeben sich aus den darauf rückbezogenen Unteransprüchen.

Gegenstand der Erfindung

Im Rahmen der Erfindung wurde ein Regelkreis für ein Versorgungsnetz mit drei Außenleitern entwickelt. Dieses Versorgungsnetz kann beispielsweise eine Nachbildung des öffentlichen Drehstromnetzes auf einer beliebigen Spannungsebene sein. Das Versorgungsnetz kann aber auch beispielsweise die Nachbildung eines Bordnetzes eines Fahrzeugs oder Flugzeugs sein. Ein Außenleiter ist entsprechend dem allgemeinen Verständnis (DIN 40108) jeder Leiter, der im Betrieb unter Spannung steht und zur Energieübertragung beitragen kann, ohne Neutralleiter zu sein.

Der Regelkreis umfasst einen Phasenschieber für jeden Außenleiter des Versorgungsnetzes, mindestens einen Sensor zur Messung der Spannung, des Stroms und/oder des Phasenwinkels in jedem Außenleiter des Versorgungsnetzes sowie mindestens eine Regeleinheit. Die Regeleinheit ist dazu ausgebildet, die Spannung, den Strom und/oder den Phasenwinkel in einem oder mehreren Außenleitern auf einen Sollwert zu regeln, indem sie aus der jeweiligen Abweichung vom Sollwert eine Phasenverschiebung als Stellgröße ermittelt und dem Phasenschieber zuführt.

Erfindungsgemäß weist der Phasenschieber einen vollanalogen Signalpfad auf, den das Signal mindestens eines Außenleiters zur Aufprägung der Phasenverschiebung durchläuft.

Hiermit ist ausdrücklich nicht verlangt, dass der Phasenschieber ausschließlich analoge Komponenten enthält. Der Phasenschieber kann sehr wohl digitale Komponenten umfassen, um beispielsweise aus der gewünschten Phasenverschiebung ein oder mehrere analoge Signale zu generieren, die anschließend in dem vollanalogen Signalpfad verwendet werden, um das Signal des mindestens einen Außenleiters zu beeinflussen. Es wurde von den Erfindern erkannt, dass für die gewünschte Abbildung des Verhaltens realer Spannungsquellen oder Erzeugungseinheiten gerade die unmittelbare Beeinflussung des Signals des Außenleiters besonders zeitkritisch ist. Sicherlich wird es bei den meisten dynamischen Vorgängen, wie etwa dem Zuschalten oder Wegschalten einer Last, erforderlich sein, dass die Regeleinheit die Phasenverschiebung fortwährend der sich ändernden Spannung, dem sich ändernden Strom und/oder dem sich ändernden Phasenwinkel auf mindestens einem Außenleiter nachführt. Die Erfinder haben jedoch erkannt, dass sich das gewünschte dynamische Verhalten auch dann noch mit hinreichender Genauigkeit nachbilden lässt, wenn dieses Nachführen der Stellgröße mit einer wesentlich geringeren Geschwindigkeit geschieht als das Umsetzen dieser Stellgröße in eine tatsächliche Phasenverschiebung durch den Phasenschieber.

Prinzipiell kann eine Phasenverschiebung auch auf digitalem Wege erzeugt werden, wie beispielsweise durch Eimerkettenspeicher, die durch spannungsgesteuerte Oszillatoren (VCO) über die Frequenz steuerbar sind, oder mit einem DSP. Abgesehen davon, dass diese digitalen Lösungen zwangsläufig immer langsamer sind als eine analoge Verarbeitung, haben sie weitere Nachteile. So sind mit den Eimerkettenspeichern nur diskrete 0,1-ms-Schritte möglich, was für viele Anwendungen nicht ausreicht. Eine Umsetzung mit einem DSP oder Mikrocontroller erzeugt ungewollte Oberschwingungen.

Die Ermittlung der optimalen Phasenverschiebung, um die Abweichung des Stroms, der Spannung und/oder der Phasenlage vom Sollwert auszuregeln, ist auf digitalem Wege deutlich einfacher als auf analogem Wege. Wenn die Regeleinheit digital arbeitet, kann insbesondere eine beliebige Vielfalt von Regelstrategien eingesetzt werden. Daher weist der Phasenschieber in einer besonders vorteilhaften Ausgestaltung der Erfindung Mittel zur Wandlung einer digital vorgelegten Phasenverschiebung in mindestens eine analoge Einflussgröße auf, anhand derer in dem vollanalogen Signalpfad das Signal des Außenleiters beeinflusst wird.

Der Regelkreis ist in beliebiger Weise in ein Gerät für die Netznachbildung integrierbar. In der einfachsten Form kann das Gerät einen mit einer Energiequelle verbindbaren Eingang und einen mit einem Prüfling verbindbaren Ausgang aufweisen, wobei zwischen den Eingang und den Ausgang der Regelkreis geschaltet ist. Vorteilhaft ist jedoch für jede Phase des Versorgungsnetzes ausgangsseitig des jeweiligen Phasenschiebers ein Leistungsverstärker vorgesehen. Dann kann die Regeleinheit beispielsweise dazu ausgebildet sein, Sensorsignale im Spannungsbereich von wenigen Volt in Stellgrößen in einem vergleichbaren Spannungsbereich (etwa Gleichspannungen zwischen 0 Volt und 1 Volt) zu übersetzen.

Der Regelkreis kann vorteilhaft insbesondere einem bestehenden Gerät für die Netznachbildung nachträglich hinzugefügt werden. Enthält ein solches Gerät beispielsweise mindestens einen Oszillator sowie für jeden Außenleiter einen Linearverstärker, so kann der Regelkreis beispielsweise zwischen den Oszillator und einen addierenden Eingang des Linearverstärkers geschaltet werden. Es können dann gerade die höherpreisigen Linearverstärker unverändert weitergenutzt werden.

In einer weiteren vorteilhaften Ausgestaltung der Erfindung sind zusätzlich in einer Phase des Versorgungsnetzes ein oder mehrere feste Phasenschieber mit einer Phasenverschiebung von insgesamt 120° vorgesehen. Zusätzlich sind in einer weiteren Phase des Versorgungsnetzes ein oder mehrere feste Phasenschieber mit einer Phasenverschiebung von insgesamt 240° vorgesehen. Die Bereitstellung des Normalzustandes eines symmetrischen Drehstromnetzes an den Prüfling erfordert dann keinen aktiven Eingriff der Regeleinheit mehr. Dafür können dann Abweichungen von diesem Normalzustand schneller umgesetzt werden.

Die Wirkung des Regelkreises beruht wesentlich auf dem Phasenschieber mit dem vollanalogen Signalpfad. Die Erfinder haben einen für ihre beabsichtigten Anwendungen geeigneten Phasenschieber im Stand der Technik nicht vorgefunden und daher einen eigenen Phasenschieber entwickelt, der somit ebenfalls Gegenstand der vorliegenden Erfindung ist. Der Phasenschieber gemäß der Erfindung kann somit insbesondere in dem Regelkreis gemäß der Erfindung als Phasenschieber zum Einsatz kommen. Er ist jedoch auf diesen Einsatzzweck nicht beschränkt.

Der Phasenschieber gemäß der Erfindung ist dazu ausgebildet, aus einem Sinussignal mit Frequenz $\omega$ und einem Kosinussignal mit gleicher Frequenz $\omega$ ein um den Winkel $\varphi$ phasenverschobenes Signal zu erzeugen. Das Kosinussignal hat eine feste Phasenbeziehung zu dem Sinussignal. Insbesondere kann das Argument der Kosinusfunktion in dem Kosinussignal zu jedem Zeitpunkt identisch sein mit dem Argument der Sinusfunktion in dem Sinussignal.

Zu diesem Zweck weist der Phasenschieber folgende Bausteine auf:

- einen ersten analogen Multiplizierer zur Multiplikation des Kosinussignals mit einem Sinus des Winkels $\varphi$,
- einen zweiten analogen Multiplizierer zur Multiplikation des Sinussignals mit einem Kosinus des Winkels $\varphi$ und
- einen analogen Addierer oder analogen Subtrahierer zur Addition der von beiden analogen Multiplizierern ausgegebenen Produkte.

Die komplexe Aufgabe der Phasenverschiebung wird somit vorteilhaft in drei Teilaufgaben zerlegt, die jeweils von preiswerten und schnellen Analogbausteinen ausgeführt werden können. Grundlage hierfür ist das Additionstheorem für das von der Zeit t abhängige Signal:

$$\sin(\omega \cdot t \pm \varphi) = \sin(\omega \cdot t) \cdot \cos(\varphi) \pm \cos(\omega \cdot t) \cdot \sin(\varphi).$$

Prinzipiell lässt sich eine Phasenverschiebung auch auf andere Weise mit Analogbausteinen realisieren, beispielsweise mit dem sogenannten Allpass-Filter. Speziell bei der dynamischen Anwendung in dem Regelkreis hat das Allpass-Filter jedoch den Nachteil, dass zur Änderung des Betrages der Phasenverschiebung ein über einen weiten Bereich veränderlicher ohmscher Widerstand benötigt wird. Der Phasenschieber gemäß der Erfindung kommt ohne veränderlichen ohmschen Widerstand aus.

Das zeitabhängige Sinussignal und das zeitabhängige Kosinussignal können aus beliebigen Quellen stammen. So können beispielsweise zwei entsprechende aufeinander synchronisierte Oszillatoren verwendet werden. In einer weiteren besonders vorteilhaften Ausgestaltung der Erfindung ist jedoch in dem Phasenschieber ein analoger Differenzierer zur Erzeugung des Kosinussignals aus dem Sinussignal, oder zur Erzeugung des Sinussignals aus dem Kosinussignal, vorgesehen. Dann muss dem Phasenschieber nur noch ein Signal zugeführt werden, beispielsweise aus einem einzigen Oszillator.

Zu diesem Zweck kann insbesondere der Ausgang des Differenzierers als Dividend einem analogen Dividierer zugeführt sein, während zugleich der Eingang des Differenzierers über einen Frequenz-Spannungs-Wandler dem Dividierer als Divisor zugeführt ist. Dadurch wird dem Umstand Rechnung getragen, dass die von dem Differenzierer ermittelte Zeitableitung des Sinus- bzw. Kosinussignals nach der Kettenregel für die Differentiation den Vorfaktor $\omega$ enthält. Dieser Vorfaktor $\omega$ wird mit dem analogen Dividierer wieder entfernt.

In einer vorteilhaften Ausgestaltung der Erfindung umfasst der Differenzierer einen Operationsverstärker, dem sein Eingangssignal über eine Reihenschaltung aus einem ersten Widerstand $R_1$ und einer ersten Kapazität $C_1$ zugeführt ist. Dem Operationsverstärker ist seine Rückkopplung über eine Parallelschaltung aus einem zweiten Widerstand $R_2$ und einer zweiten Kapazität $C_2$ zugeführt.

Unter der Voraussetzung, dass die Kreisfrequenz $\omega$ sehr klein ist gegen $1/(R_1{*}C_1)$ und gegen $1/(R_2{*}C_2)$, ergibt sich dann die Ausgangsspannung $u_A$ des Differenzierers wie folgt aus seiner Eingangsspannung $u_E = \sin(\omega t)$:

$$u_A = -R_2 C_1 \frac{du_E}{dt} = -R_2 C_1 \cdot \omega \cdot \cos(\omega \cdot t).$$

Damit die Spannungsverstärkung gleich 1 beträgt, muss das Produkt aus $R_2$, $C_1$ und $\omega$ gleich 1 sein. Mit festen Werten für $R_2$ und $C_1$ lässt sich die Spannungsverstärkung dann nur auf einer Entwurfsfrequenz $\omega$ zu 1 machen. Beträgt die Entwurfsfrequenz $\omega$ beispielsweise 400 Hz, ist die Spannungsverstärkung bei der doppelten Frequenz von 800 Hz gleich 2. Beim Einsatz des Phasenschiebers in dem Regelkreis gemäß der Erfindung wird dies jedoch durch die aktive Einwirkung der Regeleinheit auf die analogen Multiplizierer ausgeregelt. Somit lässt sich ein Regelkreis, der den Phasenschieber in der Ausgestaltung mit dem analogen Differenzierer enthält, problemlos für eine große Bandbreite an Frequenzen nutzen, etwa für typische Frequenzen in Bordnetzen von Flugzeugen (400 Hz bis 800 Hz) sowie typische Frequenzen in öffentlichen Drehstromnetzen (50 Hz / 60 Hz).

Das Minuszeichen in dem Ausdruck für $u_A$, das durch die invertierende Wirkung des Operationsverstärkers zustande kommt, kann bei der weiteren Verarbeitung in dem Regelkreis beispielsweise eliminiert werden, indem zur Addition der von beiden analogen Multiplizierern ausgegebenen Produkte ein analogerer Subtrahierer an Stelle eines analogen Addierers eingesetzt wird.

In einer weiteren besonders vorteilhaften Ausgestaltung der Erfindung ist eine digitale Schaltung zur Erzeugung des Sinus des Winkels $\varphi$ und des Kosinus des Winkels $\varphi$ vorgesehen, wobei der Sinus und der Kosinus des Winkels $\varphi$ jeweils über einen Digital-Analog-Wandler zum ersten Multiplizierer, bzw. zum zweiten Multiplizierer, geführt sind. Wie eingangs erläutert, ist in dem Regelkreis gemäß der Erfindung die Erzeugung der Stellgröße für die Phasenverschiebung deutlich weniger zeitkritisch als deren Umsetzung in dem vollanalogen Signalpfad. Daher kann zur Bestimmung des Sinus und des Kosinus des Winkels $\varphi$, die auf analogem Wege vergleichsweise aufwändig ist, auf digitalem Wege erfolgen, beispielsweise durch Abruf und/oder Interpolation von in einer Wertetabelle hinterlegten Werten.

Die digitale Schaltung kann beispielsweise durch ein Echtzeitsystem, einen Mikrocontroller oder über eine speicherprogrammierbare Steuerung angesteuert werden.

Je nach Anwendung des Phasenschiebers kann es sinnvoll oder notwendig sein, die Amplitude des Sinussignals, des Kosinussignals und/oder des phasenverschobenen Signals anzupassen. Wird beispielsweise der Phasenschieber unabhängig von dem Regelkreis gemäß der Erfindung eingesetzt und enthält er einen Differenzierer zur Bildung des Kosinussignals aus dem Sinussignal, so kann mit dem dritten analogen Multiplizierer der zuvor erwähnte, bei der Differentiation entstehende, Vorfaktor $\omega$ auch ohne aktive Regelung eliminiert werden.

Vorteilhaft ist in einem Regelkreis, der mehrere Phasenschieber gemäß der Erfindung beinhaltet, ein gemeinsamer Oszillator zur Erzeugung des Sinussignals oder Kosinussignals für alle Phasenschieber vorgesehen. Es kann dann ohne Verlust an Flexibilität der Aufwand für die fortwährende Synchronisation mehrerer Oszillatoren entfallen. Mehrere voneinander unabhängige Oszillatoren haben aus physikalischen Gründen immer eine Tendenz, auseinanderzudriften.

Spezieller Beschreibungsteil

Nachfolgend wird der Gegenstand der Erfindung anhand von Figuren erläutert, ohne dass der Gegenstand der Erfindung hierdurch beschränkt wird. Es ist gezeigt:

Figur 1: Ausführungsbeispiel eines Phasenschiebers 1, 1a-1c gemäß der Erfindung;

Figur 2: Zusammenspiel des analogen Differenzierers 16 mit den analogen Multiplizierern 13a und 13b sowie mit dem analogen Subtrahierer 15;

Figur 3: erstes Ausführungsbeispiel des Regelkreises 3 mit je einer Regeleinheit 33a, 33b, 33c für jeden Außenleiter $L_1$, $L_2$, $L_3$ des Versorgungsnetzes 31;

Figur 4: zweites Ausführungsbeispiel des Regelkreises 3 mit zentraler Regeleinheit 33.

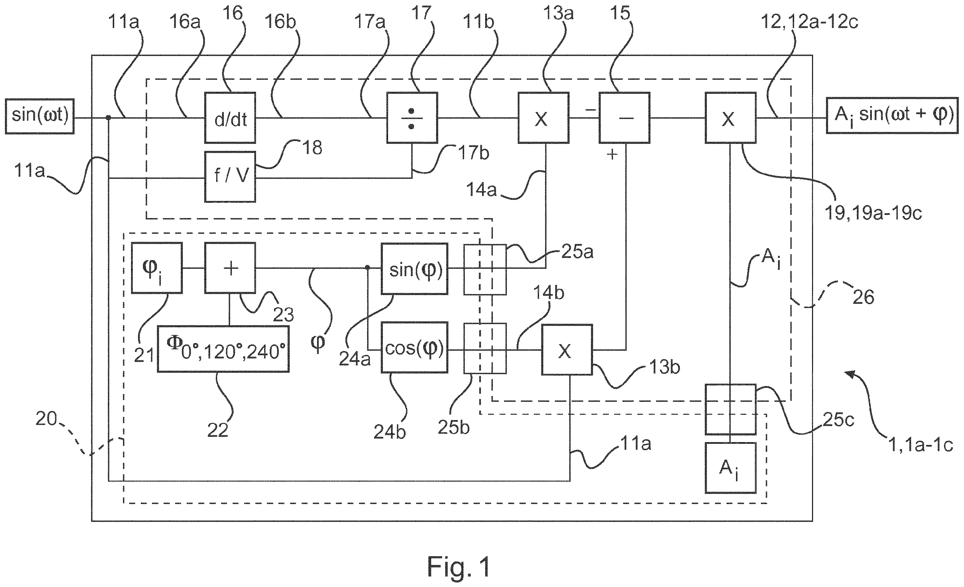

Figur 1 zeigt ein Ausführungsbeispiel eines Phasenschiebers 1, 1a-1c, der dazu ausgebildet ist, aus einem Sinussignal 11a der Form $\sin(\omega t)$ ein um den Winkel $\varphi$ phasenverschobenes und um einen Amplitudenfaktor $A_i$ verstärktes Signal 12, 12a-12c, der Form $A_i*\sin(\omega t+\varphi)$ zu bilden. Hierzu durchläuft das Sinussignal 11a einen vollanalogen Signalpfad 26, der wie folgt arbeitet:

Das Sinussignal 11a wird zugleich dem Eingang 16a eines analogen Differenzierers 16 und einem analogen Frequenz-Spannungs-Wandler 18 zugeführt. Am Ausgang 16b des Differenzierers 16 liegt dementsprechend ein Signal der Form $-\omega)*\cos(\omega t)$ an, das dem analogen Dividierer 17 als Dividend 17a zugeführt wird. Der Frequenz-Spannungs-Wandler 18 hingegen extrahiert aus dem Sinussignal 11a die Frequenz $\omega$ und führt diese dem Dividierer 17 als Divisor 17b zu. Somit liefert die Kombination aus Differenzierer 16, Dividierer 17 und Frequenz-Spannungs-Wandler 18 als Endergebnis ein Kosinussignal 11b der Form $-\cos(\omega t)$.

Der erste analoge Multiplizierer 13a multipliziert das Kosinussignal 11b mit dem Sinus 14a des Winkels $\varphi$, wobei er diesen Sinus 14a über einen ersten Digital-Analog-Wandler 25a von einer digitalen Schaltung 20 bezogen hat.

Der zweite analoge Multiplizierer 13b multipliziert das Sinussignal 11a mit dem Kosinus 14b des Winkels $\varphi$, wobei er diesen Kosinus 14b über einen zweiten Digital-Analog-Wandler 25b von der digitalen Schaltung 20 bezogen hat. Das Sinussignal 11a wird dem zweiten analogen Multiplizierer 13b auf analogem Wege zugeführt. Die entsprechende Verbindungslinie verläuft in Figur 1 nur aus Platzgründen durch den Bereich der digitalen Schaltung 20 hindurch.

Mit dem analogen Subtrahierer 15 wird das vom ersten analogen Multiplizierer 13a gelieferte Ergebnis von dem vom zweiten analogen Multiplizierer 13b gelieferten Ergebnis abgezogen. Dies ergibt insgesamt $\sin(\omega t)*\cos(\varphi)+\cos(\omega t)*\sin(\varphi)$, was nach dem Additionstheorem dem gesuchten phasenverschobenen Signal 12, 12a-12c, der Form $\sin(\omega t+\varphi)$ entspricht. Dieses Signal 12, 12a-12c, wird durch den dritten analogen Multiplizierer 19, 19a-19c, um den Amplitudenfaktor $A_i$ verstärkt.

Die digitale Schaltung 20 arbeitet wie folgt, um die benötigte Phasenverschiebung $\varphi$ zu ermitteln sowie deren Sinus $\sin(\varphi)$ und Kosinus $\cos(\varphi)$ in digitaler Form den Digital-Analog-Wandlern 25a bzw. 25b zuzuführen:

Von der in Figur 1 nicht eingezeichneten Regeleinheit 33, 33a-33c wurde für jeden Außenleiter $L_1$, $L_2$, $L_3$ eines Versorgungsnetzes 31 jeweils als Stellgröße 21 eine gewünschte Phasenverschiebung $\varphi_i$ (i=1, 2, 3) ermittelt. Hierzu wird mit dem digitalen Addierer 23 jeweils diejenige Phasenverschiebung 22 addiert, die dem Normalzustand des dreiphasigen Versorgungsnetzes 31 entspricht: Für den ersten Außenleiter $L_1$ kommen 0° zusätzliche Phasenverschiebung $\Phi_{0°}$ hinzu, für den zweiten Außenleiter $L_2$ kommen 120° zusätzliche Phasenverschiebung $\Phi_{120°}$ hinzu, und für den dritten Außenleiter $L_3$ kommen 240° zusätzliche Phasenverschiebung $\Phi_{240°}$ hinzu. Am Ausgang des digitalen Addierers 23 steht als Endergebnis die für den jeweiligen Außenleiter benötigte Gesamt-Phasenverschiebung $\varphi$ an.

Durch Interpolation mit Hilfe einer ersten Tabelle 24a wird der Sinus $\sin(\varphi)$ der Gesamt-Phasenverschiebung $\varphi$ ermittelt und anschließend dem ersten Digital-Analog-Wandler 25a zugeführt. Ebenso wird durch Interpolation mit Hilfe einer zweiten Tabelle 24b der Kosinus $\cos(\varphi)$ der Gesamt-Phasenverschiebung $\varphi$ ermittelt und dem zweiten Digital-Analog-Wandler 25b zugeführt.

Auf diese Weise werden die analogen Multiplizierer 13a und 13b in dem vollanalogen Signalpfad 26 des Phasenschiebers 1, 1a-1c mit denjenigen analogen Werten 14a des Sinus und 14b des Kosinus von $\varphi$ versorgt, die zu der in digitaler Form eingegebenen Stellgröße 21 korrespondieren. Im Ergebnis wird die Stellgröße 21 schnellstmöglich in eine Phasenverschiebung um den Winkel $\varphi$ umgesetzt.

Der Amplitudenfaktor Ai wird über einen separaten Digital-Analog-Wandler 25c dem dritten analogen Multiplizierer 19, 19a-19c im vollanalogen Signalpfad 26 zugeführt.

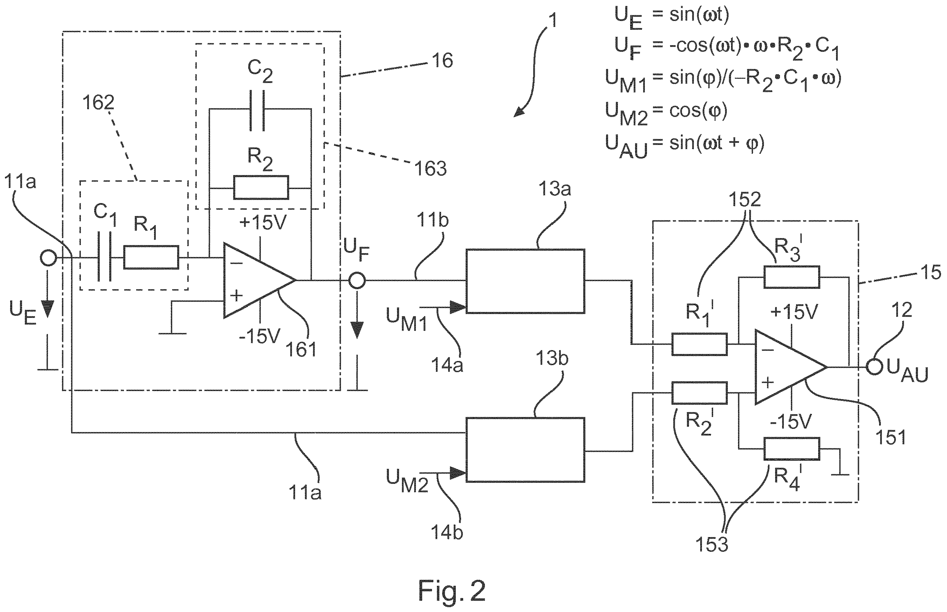

Figur 2 zeigt beispielhaft das Zusammenspiel des analogen Differenzierers 16 mit den analogen Multiplizierern 13a und 13b sowie mit dem analogen Subtrahierer 15 in dem Phasenschieber 1, sowie beispielhafte innere Schaltaufbauten für den analogen Differenzierer 16 und den analogen Subtrahierer 15. Der Differenzierer 16 umfasst einen Operationsverstärker 161. Dem Operationsverstärker 161 ist sein Eingangssignal über eine Reihenschaltung 162 aus einem ersten Widerstand $R_1$ und einer ersten Kapazität $C_1$ zugeführt. Der Operationsverstärker 161 erhält seine Rückkopplung über eine Parallelschaltung 163 aus einem zweiten Widerstand $R_2$ und einer zweiten Kapazität $C_2$.

Im Unterschied zu Figur 1 fehlt in Figur 2 die Kombination aus dem analogen Frequenz-Spannungs-Wandler 18 mit dem analogen Dividierer 17. Stattdessen wurde der Sinus 14a der Phasenverschiebung $\varphi$ bereits in der in Figur 2 nicht eingezeichneten digitalen Schaltung 20 durch $-R_2*C_1*\omega$ dividiert.

Der analoge Subtrahierer 15 enthält wiederum einen Operationsverstärker 151. Der invertierende Eingang des Operationsverstärkers 151 ist in der Mitte eines ersten Spannungsteilers 152 aus den Widerständen $R_1'$ und $R_3'$ zwischen dem Ausgang des ersten analogen Multiplizierers 13a und dem Niveau des Ausgangssignals 12. Der nicht invertierende Eingang des Operationsverstärkers 151 ist in der Mitte eines zweiten Spannungsteilers 153 aus den Widerständen $R_2'$ und $R_4'$ zwischen dem Ausgang des zweiten analogen Multiplizierers 13b und Masse.

Zur Veranschaulichung sind in Figur 2 die im Betrieb an den Punkten $U_E$, $U_F$, $U_{M1}$, $U_{M2}$ sowie $U_{AU}$ anliegenden Spannungen angegeben.

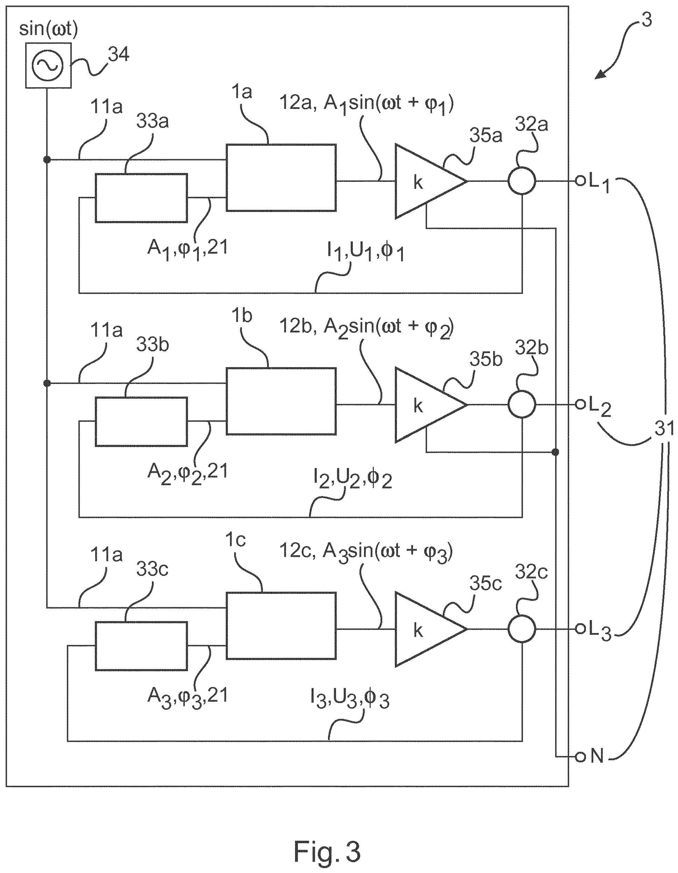

Figur 3 zeigt ein erstes Ausführungsbeispiel für einen vollständigen Regelkreis 3 für ein Versorgungsnetz 31 mit drei Außenleitern $L_1$, $L_2$ und $L_3$ sowie einem Neutralleiter N.

Mit jedem Außenleiter $L_1$, $L_2$, $L_3$ ist ein zugehöriger Sensor 32a, 32b, 32c gekoppelt, der einen Messwert $U_1$, $U_2$, $U_3$ für die jeweilige Spannung, einen Messwert $I_1$, $I_2$, $I_3$ für den jeweiligen Strom, und/oder einen Messwert $\phi_1$, $\phi_2$, $\phi_3$ für die jeweilige Phasenlage, erfasst und an eine jeweils zugeordnete Regeleinheit 33a, 33b, 33c übermittelt.

Die erste Regeleinheit 33a prüft, inwieweit der Messwert des Sensors 32a vom zugehörigen Sollwert abweicht, und ermittelt eine Phasenverschiebung $\varphi_1$ sowie einen Amplitudenfaktor $A_1$ als Stellgrößen 21, um diese Abweichung auszuregeln. Diese Stellgrößen 21 werden an den ersten Phasenschieber 1a übermittelt. Der erste Phasenschieber 1a erhält ein Sinussignal 11a von einem gemeinsamen Oszillator 34 und erzeugt hieraus ein erstes Ausgangssignal 12a, das um den Winkel $\varphi_1$ phasenverschoben und um den Faktor $A_1$ verstärkt ist. Dieses Signal wird mit einem ersten Leistungsverstärker 35a um den Faktor k verstärkt.

Die zweite Regeleinheit 33b prüft, inwieweit der Messwert des Sensors 32b vom zugehörigen Sollwert abweicht, und ermittelt eine Phasenverschiebung $\varphi_2$ sowie einen Amplitudenfaktor $A_2$ als Stellgrößen 21, um diese Abweichung auszuregeln. Diese Stellgrößen 21 werden an den zweiten Phasenschieber 1b übermittelt. Der zweite Phasenschieber 1b erhält das Sinussignal 11a von dem gemeinsamen Oszillator 34 und erzeugt hieraus ein zweites Ausgangssignal 12b, das um den Winkel $\varphi_2$ phasenverschoben und um den Faktor $A_2$ verstärkt ist. Dieses Signal wird mit einem zweiten Leistungsverstärker 35b um den Faktor k verstärkt.

Die dritte Regeleinheit 33c prüft, inwieweit der Messwert des Sensors 32c vom zugehörigen Sollwert abweicht, und ermittelt eine Phasenverschiebung $\varphi_3$ sowie einen Amplitudenfaktor $A_3$ als Stellgrößen 21, um diese Abweichung auszuregeln. Diese Stellgrößen 21 werden an den dritten Phasenschieber 1c übermittelt. Der dritte Phasenschieber 1c erhält das Sinussignal 11a von dem gemeinsamen Oszillator 34 und erzeugt hieraus ein drittes Ausgangssignal 12c, das um den Winkel $\varphi_3$ phasenverschoben und um den Faktor $A_3$ verstärkt ist. Dieses Signal wird mit einem dritten Leistungsverstärker 35c um den Faktor k verstärkt.

Das aus den drei Leistungsverstärkern 35a, 35b, 35c gespeiste Versorgungsnetz 31 versorgt den in Figur 3 nicht eingezeichneten Prüfling. Die Regeleinheiten 33a-33c haben eine doppelte Funktion. Zum Einen können über die entsprechenden Sollwerte beliebige Netzzustände simuliert werden, wie beispielsweise eine unsymmetrische Speisung. Zum Anderen kann über die Regelcharakteristik, mit der die Regeleinheiten 33a-33c bei plötzlichen Änderungen der Messwerte der Sensoren 32a-32c eingreifen, das dynamische Verhalten jeder Art von Energiequelle simuliert werden. So kann beispielsweise das Verhalten von Wechselrichtern, Inselgeneratoren oder Generatoren mit angeschlossenen Netzen simuliert werden. Auf diese Weise kann beispielsweise geprüft werden, wie ein Gerät mit hohem Einschaltstrombedarf darauf reagiert, dass ein aus einem Solar-Akku gespeister Wechselrichter auf Grund des Innenwiderstandes des Solar-Akkus den Einschaltstrombedarf nicht vollständig decken kann.

Insbesondere kann auch das Zusammenspiel mehrerer Verbraucher, die über ein Versorgungsnetz mit begrenzter Kapazität versorgt werden sollen, untersucht werden. Soll beispielsweise auf freiem Feld ein Konzert mit Beschallung, Licht und weiteren Verbrauchern aus einem mobilen Stromaggregat versorgt werden, so kann beispielsweise eine bereits vorhandene unsymmetrische Belastung der drei Außenleiter beim Einschalten eines weiteren Verbrauchers zu Fehlfunktionen desselben führen. Das Verhalten der Installation kann dann etwa davon abhängen, in welcher Reihenfolge die Verbraucher zugeschaltet werden. Mit dem flexiblen Regelkreis 3 können derartige Probleme bereits im Vorfeld der Veranstaltung identifiziert werden zu einem Zeitpunkt, zu dem es etwa noch möglich ist, ein sich dynamisch als zu schwach erweisendes Betriebsmittel durch ein besser geeignetes zu ersetzen.

Ein anderes Anwendungsbeispiel sind sogenannte DXpeditionen von Amateurfunkern in unzugängliche Gegenden, um mit einer Vielzahl von Geräten von dort aus Funkkontakte in alle Welt herzustellen. Wenn mehrere Tagesreisen von der Zivilisation entfernt die Geräte nicht wie geplant funktionieren, weil etwa beim Druck auf die Morsetaste der Generator den schnell ansteigenden Leistungsbedarf der Endstufe nicht decken kann, ist ein Gerätetausch nicht mehr möglich, so dass möglicherweise erhebliche Abstriche beim Betrieb gemacht werden müssen oder die investierten Gesamtkosten von bis zu mehreren 100.000 € komplett auf dem Spiel stehen. Der Vortest der beabsichtigten Installation mit Hilfe des Regelkreises 3 kann helfen, derartige Situationen mit maximalem Stress für alle Beteiligten zu vermeiden.

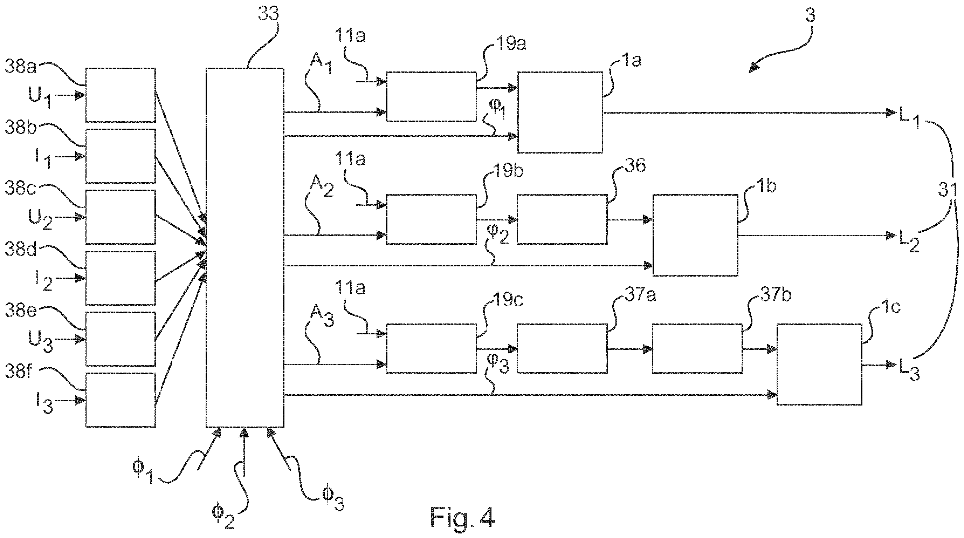

Figur 4 zeigt ein weiteres Ausführungsbeispiel des Regelkreises 3 mit einem anderen konstruktiven Aufbau. Im Unterschied zu Figur 3 erhält eine zentrale Regeleinheit 33 die Messwerte für die Spannungen $U_1$, $U_2$, $U_3$ und für die Ströme $I_1$, $I_2$, $I_3$ auf den Außenleitern $L_1$, $L_2$, $L_3$ über Präzisionsgleichrichter 38a-38f. Weiterhin erhält die zentrale Regeleinheit 33 auch die Phasenlagen der Außenleiter $L_1$, $L_2$, $L_3$, wobei hierfür keine Gleichrichter nötig sind.

Im Unterschied zu Figur 1 findet die Multiplikation mit den Amplitudenfaktoren $A_1$, $A_2$, $A_3$ durch die weiteren

analogen Multiplizierer 19a, 19b, 19c statt, bevor die Phasen der Außenleiter $L_1$, $L_2$, $L_3$ verschoben werden. Weiterhin im Unterschied zu Figur 1 sind die Phasenschieber 1a, 1b und 1c nur für die variablen Phasenverschiebungen um die von der zentralen Regeleinheit 33 vorgegebenen Beträge $\varphi_1$, $\varphi_2$, $\varphi_3$ zwischen 0° und -180° zuständig. Die Phasenverschiebung des Außenleiters $L_2$ gegenüber dem Außenleiter $L_1$ um 120° wird hingegen durch einen ersten festen Phasenschieber 36 bewirkt. Weiterhin wird die Phasenverschiebung des Außenleiters $L_3$ gegenüber dem Außenleiter $L_1$ um 240° durch eine Kaskade aus zwei weiteren festen Phasenschiebern 37a und 37b, die jeweils beide eine Phasenverschiebung von 120° bewirken und insbesondere jeweils mit dem ersten festen Phasenschieber 36 identisch sein können, bewirkt. Die festen Phasenschieber 36, 37a und 37b stellen den symmetrischen Normalzustand des Versorgungsnetzes 31 ein, so dass die zentrale Regeleinheit 33 nur noch für Abweichungen hiervon zuständig ist.

**Bezugszeichenliste**

| | |
|---|---|
| 1, 1a-1c | Phasenschieber |
| 11a | in der Phase zu verschiebendes Sinussignal |
| 11b | Kosinussignal mit gleicher Frequenz wie Signal 11a |
| 12, 12a-12c | aus Signalen 11a, 11b erzeugtes phasenverschobenes Signal |
| 13a | erster analoger Multiplizierer, erhält Signal 11b und Sinus 14a |
| 13b | zweiter analoger Multiplizierer, erhält Signal 11a und Kosinus 14b |
| 14a | Sinus der Phasenverschiebung $\varphi$ (Analogwert) |
| 14b | Kosinus der Phasenverschiebung $\varphi$ (Analogwert) |
| 15 | analoger Addierer oder Subtrahierer |
| 151 | Operationsverstärker in Addierer oder Subtrahierer 15 |
| 152 | Spannungsteiler am invertierenden Eingang des Verstärkers 151 |
| 153 | Spannungsteiler am nichtinvertierenden Eingang des Verstärkers 151 |
| 16 | analoger Differenzierer |
| 161 | Operationsverstärker in Differenzierer 16 |
| 162 | Reihenschaltung am invertierenden Eingang des Verstärkers 161 |
| 163 | Parallelschaltung in Rückkopplung des Verstärkers 161 |
| 17 | analoger Dividierer |
| 17a | Eingang des analogen Dividierers 17 |
| 17b | Ausgang des analogen Dividierers 17 |
| 18 | analoger Frequenz-Spannungs-Wandler |
| 19, 19a-19c | dritter analoger Multiplizierer für Amplitudenfaktor $A_i$ |
| 20 | digitale Schaltung zur Generierung von $\sin(\varphi)$ und $\cos(\varphi)$ |
| 21 | gewünschte Phasenverschiebung $\varphi_i$, Stellgröße |
| 22 | feste Phasenverschiebung für Außenleiter $L_2$, $L_3$ |
| 23 | digitaler Addierer zur Bildung von $\varphi$ |
| 24a | Tabelle für Interpolation von $\sin(\varphi)$ |
| 24b | Tabelle für Interpolation von $\cos(\varphi)$ |
| 25a | Digital-Analog-Wandler für Sinus 14a |
| 25b | Digital-Analog-Wandler für Kosinus 14b |
| 25c | Digital-Analog-Wandler für Amplitudenfaktor $A_i$ |
| 26 | vollanaloger Signalpfad in Phasenschieber 1, 1a-1c |
| 3 | Regelkreis für Versorgungsnetz 31 |
| 31 | Versorgungsnetz mit Außenleitern $L_1$, $L_2$, $L_3$ |
| 32a-32c | Sensoren für Außenleiter $L_1$, $L_2$, $L_3$ |
| 33, 33a-33c | Regeleinheiten |
| 34 | gemeinsamer Oszillator für Phasenschieber 1a-1c |
| 35a-35c | Leistungsverstärker für Außenleiter $L_1$, $L_2$, $L_3$ |
| 36 | fester Phasenschieber für Außenleiter $L_2$ |
| 37a, 37b | feste Phasenschieber für Außenleiter $L_3$ |
| 38a-38f | Präzisionsgleichrichter für Messwerte $U_1$-$U_3$, $I_1$-$I_3$ |
| $A_i$ | Amplitudenfaktor für Außenleiter i |
| $C_1$ | Kapazität in Reihenschaltung 162 |
| $C_2$ | Kapazität in Parallelschaltung 163 |
| $I_1$, $I_2$, $I_3$ | gemessene Ströme auf Außenleitern $L_1$, $L_2$, $L_3$ |

| $L_1, L_2, L_3$ | Außenleiter des Versorgungsnetzes 31 |
|---|---|
| $N$ | Neutralleiter des Versorgungsnetzes 31 |
| $R_1$ | Widerstand in Reihenschaltung 162 |
| $R_2$ | Widerstand in Parallelschaltung 162 |
| $R_1', R_3'$ | Widerstände in Spannungsteiler 152 |
| $R_2', R_4'$ | Widerstände in Spannungsteiler 153 |
| $U_1, U_2, U_3$ | gemessene Spannungen auf Außenleitern $L_1, L_2, L_3$ |
| $\phi_1, \phi_2, \phi_3$ | gemessene Phasenlagen auf Außenleitern $L_1, L_2, L_3$ |
| $\varphi_1, \varphi_2, \varphi_3$ | Phasenverschiebungen für Außenleiter $L_1, L_2, L_3$ als Stellgröße 21 |
| $\varphi$ | Gesamt-Phasenverschiebung für Phasenschieber 1, 1a-1c |

## Patentansprüche

1. Regelkreis (3) für ein Versorgungsnetz (31) mit drei Außenleitern ($L_1, L_2, L_3$), umfassend einen Phasenschieber (1, 1a-1c) für jeden Außenleiter ($L_1, L_2, L_3$) des Versorgungsnetzes (31), mindestens einen Sensor (32a-32c) zur Messung der Spannung ($U_1, U_2, U_3$), des Stroms ($I_1, I_2, I_3$) und/oder des Phasenwinkels ($\phi_1, \phi_2, \phi_3$) in jedem Außenleiter ($L_1, L_2, L_3$) des Versorgungsnetzes (31) sowie mindestens eine Regeleinheit (33, 33a-33c), wobei die Regeleinheit (33, 33a-33c) dazu ausgebildet ist, die Spannung ($U_1, U_2, U_3$), den Strom ($I_1, I_2, I_3$) und/oder den Phasenwinkel ($\phi_1, \phi_2, \phi_3$) in einem oder mehreren Außenleitern ($L_1, L_2, L_3$) auf einen Sollwert zu regeln, indem sie aus der jeweiligen Abweichung vom Sollwert eine Phasenverschiebung ($\varphi_1$-$\varphi_3$) als Stellgröße (21) ermittelt und dem Phasenschieber (1, 1a-1c) zuführt, **dadurch gekennzeichnet, dass** der Phasenschieber (1, 1a-1c) einen vollanalogen Signalpfad (26) aufweist, den das Signal mindestens eines Außenleiters ($L_1, L_2, L_3$) zur Aufprägung der Phasenverschiebung ($\varphi_1$-$\varphi_3$) durchläuft.

2. Regelkreis (3) nach Anspruch 1, **dadurch gekennzeichnet, dass** der Phasenschieber (1, 1a-1c) Mittel (20, 25a-25c) zur Wandlung einer digital vorgelegten Phasenverschiebung ($\varphi_1$-$\varphi_3$) in mindestens eine analoge Einflussgröße aufweist, anhand derer in dem vollanalogen Signalpfad (26) das Signal des Außenleiters ($L_1, L_2, L_3$) beeinflusst wird.

3. Regelkreis (3) nach einem der Ansprüche 1 bis 2, **dadurch gekennzeichnet, dass** für jede Phase ($L_1, L_2, L_3$) des Versorgungsnetzes (31) ausgangsseitig des jeweiligen Phasenschiebers (1, 1a-1c) ein Leistungsverstärker (35a-35c) vorgesehen ist.

4. Regelkreis (3) nach einem der Ansprüche 1 bis 3, **dadurch gekennzeichnet, dass** zusätzlich in einer Phase ($L_2$) des Versorgungsnetzes (31) ein oder mehrere feste Phasenschieber (36, 22) mit einer Phasenverschiebung von insgesamt 120° vorgesehen sind und dass zusätzlich in einer weiteren Phase ($L_3$) des Versorgungsnetzes (31) ein oder mehrere feste Phasenschieber (37a, 37b, 22) mit einer Phasenverschiebung von insgesamt 240° vorgesehen sind.

5. Phasenschieber (1, 1a-1c) zur Erzeugung eines um einen Winkel $\varphi$ phasenverschobenen Signals (12, 12a-12c) aus einem Sinussignal (11a) mit Frequenz $\omega$ und einem Kosinussignal (11b) mit gleicher Frequenz $\omega$, umfassend:

   • einen ersten analogen Multiplizierer (13a) zur Multiplikation des Kosinussignals (11b) mit einem Sinus (14a) des Winkels $\varphi$,
   • einen zweiten analogen Multiplizierer (13b) zur Multiplikation des Sinussignals (11a) mit einem Kosinus (14b) des Winkels $\varphi$ und
   • einen analogen Addierer oder analogen Subtrahierer (15) zur Addition der von beiden analogen Multiplizierern ausgegebenen Produkte.

6. Phasenschieber (1, 1a-1c) nach Anspruch 5, **dadurch gekennzeichnet, dass** ein analoger Differenzierer (16) zur Erzeugung des Kosinussignals (11b) aus dem Sinussignal (11a), oder zur Erzeugung des Sinussignals (11a) aus dem Kosinussignal (11b), vorgesehen ist.

7. Phasenschieber (1, 1a-1c) nach Anspruch 6, **dadurch gekennzeichnet, dass** der Ausgang (16b) des Differenzierers (16) als Dividend (17a) einem analogen Dividierer (17) zugeführt ist, während zugleich der Eingang (16a) des Differenzierers (16) über einen analogen Frequenz-Spannungs-Wandler (18) dem Dividierer (17) als Divisor (17b) zugeführt ist.

8. Phasenschieber (1, 1a-1c) nach einem der Ansprüche 6 bis 7, **dadurch gekennzeichnet, dass** der Differenzierer (16) einen Operationsverstärker (161) umfasst, dem sein Eingangssignal über eine Reihenschaltung (162) aus einem ersten Widerstand $R_1$ und einer ersten Kapazität $C_1$ zugeführt ist und dem seine Rückkopplung über eine Parallelschaltung (163) aus einem zweiten Widerstand $R_2$ und einer zweiten Kapazität $C_2$ zugeführt ist.

9. Phasenschieber (1, 1a-1c) nach einem der Ansprüche 5 bis 8, **dadurch gekennzeichnet, dass** eine digitale Schaltung (20) zur Erzeugung des Sinus (14a) des Winkels φ und des Kosinus (14b) des Winkels φ vorgesehen ist, wobei der Sinus (14a) und der Kosinus (14) des Winkels φ jeweils über einen Digital-Analog-Wandler (25a, 25b) zum ersten Multiplizierer (13a), bzw. zum zweiten Multiplizierer (13b), geführt sind.

10. Phasenschieber (1, 1a-1c) nach einem der Ansprüche 5 bis 9, **dadurch gekennzeichnet, dass** ein dritter analoger Multiplizierer (19, 19a-19c) zur Multiplikation des Sinussignals (11a), des Kosinussignals (11b) und/oder des phasenverschobenen Signals (12, 12a-12c) mit einem Amplitudenfaktor ($A_i$) vorgesehen ist.

11. Regelkreis (3) nach einem der Ansprüche 1 bis 3, **dadurch gekennzeichnet, dass** der Phasenschieber (1, 1a-1c) ein Phasenschieber nach einem der Ansprüche 4 bis 8 ist.

12. Regelkreis (3) nach Anspruch 11, **dadurch gekennzeichnet, dass** ein gemeinsamer Oszillator (34) zur Erzeugung des Sinussignals (11a) oder Kosinussignals (11b) für alle Phasenschieber (1, 1a-1c) vorgesehen ist.

Fig. 1

EP 3 493 404 A2

Fig. 2

$U_E = \sin(\omega t)$
$U_F = -\cos(\omega t) \cdot \omega \cdot R_2 \cdot C_1$
$U_{M1} = \sin(\varphi)/(-R_2 \cdot C_1 \cdot \omega)$
$U_{M2} = \cos(\varphi)$
$U_{AU} = \sin(\omega t + \varphi)$

Fig. 3

Fig. 4

EP 3 493 404 A2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- GB 1312618 A